(19) Europäisches Patentamt
European Patent Office
Office européen des brevets

(11) **EP 3 714 667 B1**

(12) **FASCICULE DE BREVET EUROPEEN**

(45) Date de publication et mention
de la délivrance du brevet:
**14.05.2025 Bulletin 2025/20**

(21) Numéro de dépôt: **18803422.7**

(22) Date de dépôt: **16.11.2018**

(51) Classification Internationale des Brevets (IPC):
**H05K 7/20** (2006.01)

(52) Classification Coopérative des Brevets (CPC):
**H05K 7/209**

(86) Numéro de dépôt international:
**PCT/EP2018/081510**

(87) Numéro de publication internationale:
**WO 2019/101634 (31.05.2019 Gazette 2019/22)**

(54) **MODULE ÉLECTRIQUE DE PUISSANCE**

ELEKTRISCHES LEISTUNGSMODUL

ELECTRICAL POWER MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.11.2017 FR 1761015**

(43) Date de publication de la demande:
**30.09.2020 Bulletin 2020/40**

(73) Titulaire: **Safran Electronics & Defense
92100 Boulogne-Billancourt (FR)**

(72) Inventeurs:
• **RIOU, Jean-Christophe
77550 MOISSY-CRAMAYEL (FR)**
• **BAILLY, Eric
77550 MOISSY-CRAMAYEL (FR)**
• **SRIDI-CONVERS,Nawres
77550 MOISSY-CRAMAYEL (FR)**

(74) Mandataire: **Cabinet Boettcher
5, rue de Vienne
75008 Paris (FR)**

(56) Documents cités:
**EP-A1- 0 886 315**    **DE-U1- 29 504 352**
**US-A1- 2010 165 576**    **US-A1- 2013 069 108**
**US-A1- 2016 105 004**

## Description

L'invention concerne le domaine des modules électriques de puissance.

### ARRIERE PLAN DE L'INVENTION

Un module électrique de puissance comporte très classiquement des semi-conducteurs jouant le rôle d'interrupteurs. Les semi-conducteurs sont montés sur un substrat électriquement isolant.

Le module électrique de puissance comprend par exemple un onduleur destiné à piloter un moteur électrique d'un actionneur électromécanique.

Les semi-conducteurs sont par exemple des transistors de puissance de type JFET, IGBT ou MOSFET.

Le substrat est par exemple constitué d'une couche en céramique qui présente, sur chacune de ses faces, une couche de métallisation. Outre l'isolation électrique, le rôle du substrat est de réaliser un transfert du flux de chaleur dissipé par les semi-conducteurs.

Un tel module électrique de puissance comporte aussi classiquement une semelle qui évacue le flux de chaleur et qui assure un maintien mécanique du module électrique de puissance. La semelle est généralement fabriquée en cuivre ou en aluminium, et est habituellement montée sur un dissipateur thermique.

Le fonctionnement du module électrique de puissance génère des cycles de température pouvant être relativement sévères. Les cycles de température produisent d'importantes contraintes mécaniques dans le substrat et au niveau des interfaces entre le substrat et les semi-conducteurs. Ces contraintes mécaniques et thermiques sont à l'origine de multiples modes de défaillance du module électrique de puissance, et tendent à augmenter la probabilité de la survenue d'une panne dans le module électrique de puissance. Le document US2016/105004A1 divulgue un module électrique de puissance comprenant les caractéristiques du préambule de la revendication 1.

### OBJET DE L'INVENTION

L'invention a pour objet de réduire la probabilité de la survenue d'une panne dans un module électrique de puissance.

### RESUME DE L'INVENTION

En vue de la réalisation de ce but, on propose un module électrique de puissance comportant des composants de puissance et des supports comprenant chacun au moins une portion métallique, les portions métalliques des supports formant un substrat du module électrique de puissance, au moins un support comprenant deux portions métalliques orientées l'une par rapport à l'autre d'un angle d'orientation supérieur à 0°, les deux portions métalliques orientées étant orthogonales entre elles et un composant de puissance distinct étant fixé sur chacune desdites deux portions métalliques orientées, chaque composant de puissance étant fixé à deux portions métalliques de deux supports distincts en étant positionné entre lesdites deux portions métalliques, le module électrique de puissance étant agencé de sorte que des courants électriques de puissance provenant ou à destination des composants de puissance circulent dans les portions métalliques des supports.

Les supports du module électrique de puissance, dans lesquels circulent les courants électriques de puissance, permettent une dissipation de chaleur tri-modale simultanée, par conduction, convexion et radiation. Cette dissipation de chaleur est particulièrement efficace. Par ailleurs, le substrat du module électrique de puissance est métallique et ne comporte pas de couche céramique fragilisée par les cycles thermiques.

On propose aussi un actionneur électromécanique comportant un module électrique de puissance tel que celui qui vient d'être décrit et un moteur électrique.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :

- la figure 1 représente un schéma électrique d'un onduleur d'un module électrique de puissance selon l'invention ;
- la figure 2 est une vue en section du module électrique de puissance selon l'invention ;
- la figure 3 est une vue de détail de la figure 2 ;
- la figure 4 est une vue en section d'une cellule de puissance générique du module électrique de puissance selon un exemple ne faisant pas partie de l'objet de la protection demandée ;
- la figure 5 est une vue en section du module électrique de puissance selon l'invention, sur laquelle un capot en plastique est représenté.

### DESCRIPTION DETAILLEE DE L'INVENTION

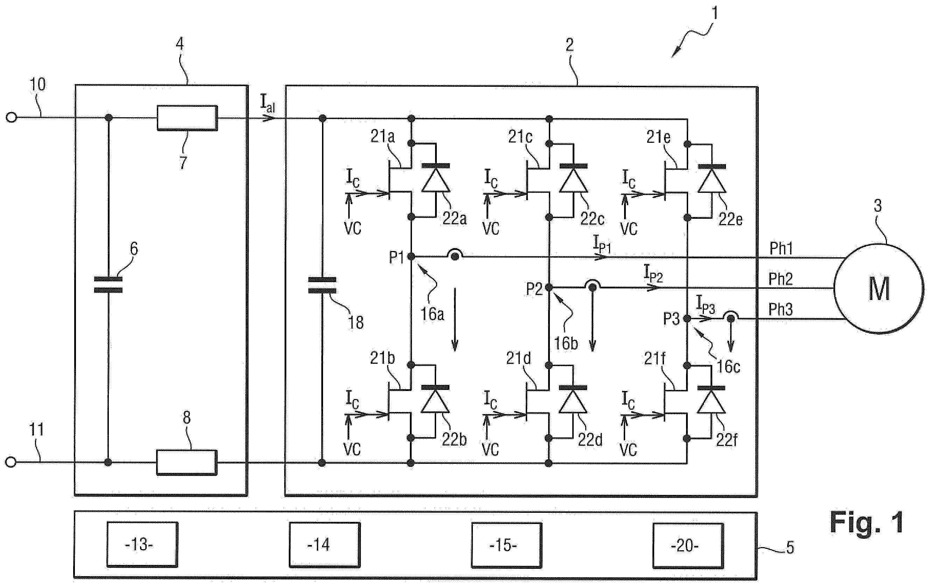

En référence à la figure 1, le module électrique de puissance selon l'invention 1 comprend des composants de puissance formant un onduleur 2.

L'onduleur 2 appartient à un système électrique intégré dans un actionneur électromécanique.

Outre le système électrique, l'actionneur électromécanique comporte un moteur électrique triphasé 3 (ainsi que d'autres éléments non représentés, et notamment un organe d'actionnement). Le moteur 3 est alimenté et piloté via l'onduleur 2.

Outre l'onduleur 2, le système électrique comporte un circuit de liaison 4 et un module additionnel 5.

Le circuit de liaison 4 comporte une capacité de liaison 6, un premier composant de liaison 7 et un deuxième composant de liaison 8.

Le circuit de liaison 4 est connecté à un générateur de puissance, non représenté sur la figure 1, qui produit une tension d'alimentation continue positive sur un conducteur d'alimentation positive 10, et une tension d'alimentation continue négative sur un conducteur d'alimentation négative 11. Le générateur de puissance produit aussi un courant électrique d'alimentation Ial qui circule sur le conducteur d'alimentation positive 10 et sur le conducteur d'alimentation négative 11.

La capacité de liaison 6 est montée en parallèle entre le conducteur d'alimentation positive 10 et le conducteur d'alimentation négative 11.

Le premier composant de liaison 7, représenté par une impédance, est monté sur le conducteur d'alimentation positive 10. Le deuxième composant de liaison 8, représenté par une impédance, est monté sur le conducteur d'alimentation négative 11.

Le module additionnel 5 comprend, de manière classique, un circuit de pilotage 13, un circuit de surveillance 14, un circuit de protection 15 et un circuit de mesure 20. Les circuits du module additionnel 5 sont notamment utilisés pour piloter l'onduleur 2 et donc le moteur 3, et pour surveiller et protéger l'onduleur 2 et le moteur 3.

Les composants de puissance de l'onduleur 2 comprennent une capacité 18 montée en parallèle entre le conducteur d'alimentation positive 10 et le conducteur d'alimentation négative 11, ainsi que trois bras de pont 16 montés en parallèle et comprenant chacun deux transistor 21 de type JFET. Dans un même bras de pont 16, les deux transistors 21 découpent le signal de manière alternée dans une même phase de fonctionnement lors de l'actionnement séquentiel de leur gâchette.

Une diode 22 est montée entre le drain et la source de chaque transistor 21.

On définit ainsi un premier bras de pont 16a comprenant un premier transistor 21a, une première diode 22a, un deuxième transistor 21b, une deuxième diode 22b, un deuxième bras de pont 16b comprenant un troisième transistor 21c, une troisième diode 22c, un quatrième transistor 21d, une quatrième diode 22d, et un troisième bras de pont 16c comprenant un cinquième transistor 21e, une cinquième diode 22e, un sixième transistor 21f, une sixième diode 22f.

Un premier point milieu P1 est situé sur le premier bras de pont 16a entre le premier transistor 21a et le deuxième transistor 21b. Un deuxième point milieu P2 est situé sur le deuxième bras de pont 16b entre le troisième transistor 21c et le quatrième transistor 21d. Un troisième point milieu P3 est situé sur le troisième bras de pont 16c entre le cinquième transistor 21e et le sixième transistor 21f.

Le premier point milieu P1 est relié à une première phase Ph1 du moteur 3, le deuxième point milieu P2 est relié à une deuxième phase Ph2 du moteur 3, et le troisième point milieu P3 est relié à une troisième phase Ph3 du moteur 3.

Les grilles des transistors 21 sont reliées au circuit de pilotage 13 du module additionnel 5. Le circuit de pilotage 13 génère des courants électriques de commande Ic sous des tensions électriques de commande Vc appliquées sur les grilles des transistors 21 pour piloter les transistors 21 et donc le moteur 3.

Les drains du premier transistor 21a, du troisième transistor 21c et du cinquième transistor 21e sont reliés au conducteur d'alimentation positive 10.

Les sources du deuxième transistor 21b, du quatrième transistor 21d et du sixième transistor 21f sont reliées au conducteur d'alimentation négative 11.

Les sources du premier transistor 21a, du troisième transistor 21c et du cinquième transistor 21e sont reliées respectivement au drain du deuxième transistor 21b, au drain du quatrième transistor 21d et au drain du sixième transistor 21f.

Un premier courant de phase Ip1, à destination de la première phase Ph1 du moteur 3, est produit par le premier bras de pont 16a. Un deuxième courant de phase Ip2, à destination de la deuxième phase Ph2 du moteur 3, est produit par le deuxième bras de pont 16b. Un troisième courant de phase Ip3, à destination de la troisième phase Ph3 du moteur 3, est produit par le troisième bras de pont 16c.

Le premier courant de phase Ip1, le deuxième courant de phase Ip2 et le troisième courant de phase Ip3 sont des courants de sortie alternatifs de l'onduleur 2, qui alimentent le moteur 3.

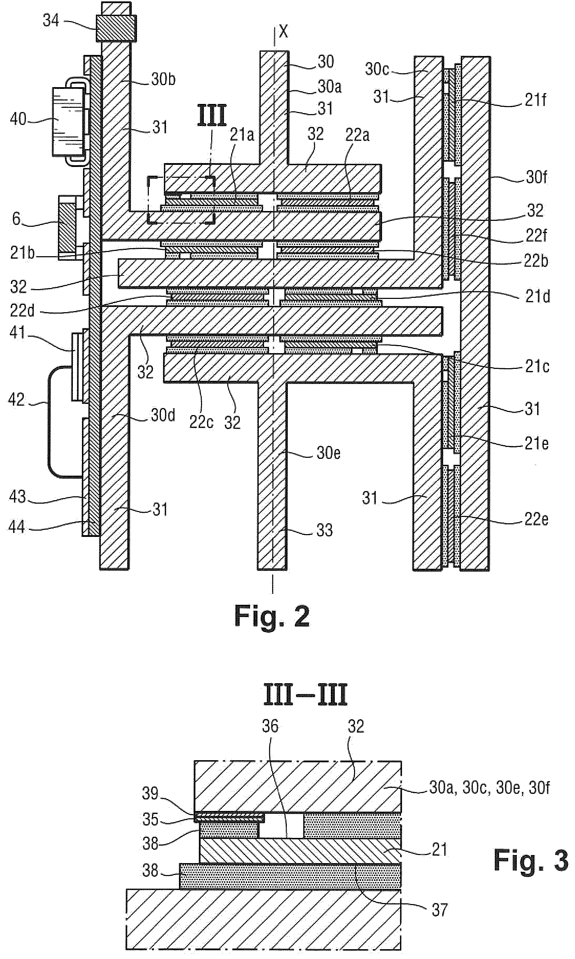

En référence à la figure 2, le module électrique de puissance 1 comporte des supports 30 qui portent les composants de puissance de l'onduleur 2.

Les supports 30 sont assemblés entre eux de manière à ce que le module électrique de puissance 1 présente une forme extérieure générale tubulaire de section circulaire et d'axe longitudinal un axe X.

Les supports 30 comprennent ici un premier support 30a, un deuxième support 30b, un troisième support 30c, un quatrième support 30d, un cinquième support 30e et un sixième support 30f.

La figure 2 est une vue en section du module électrique de puissance selon un plan parallèle à l'axe X et comprenant l'axe X.

Dans la vue de la figure 2, le premier support 30a présente la forme d'un T. Le premier support 30a comporte une première portion métallique 31 et une deuxième portion métallique 32 orientées l'une par rapport à l'autre d'un angle d'orientation supérieur à 0°. Ici, la première portion métallique 31 et la deuxième portion métallique 32 sont orthogonales entre elles.

Le deuxième support 30b, le troisième support 30c et le quatrième support 30d présentent la forme d'un angle droit. Le deuxième support 30b, le troisième support 30c et le quatrième support 30d comportent ainsi chacun une première portion métallique 31 et une deuxième portion métallique 32 orientées l'une par rapport à l'autre d'un angle d'orientation supérieur à 0°. Ici, la première portion métallique 31 et la deuxième portion métallique 32 sont orthogonales entre elles.

Le cinquième support 30e présente la forme d'un F et comporte une première portion métallique 31, une deuxième portion métallique 32 et une troisième portion métallique 33.

La deuxième portion métallique 32 du cinquième support 30e, la première portion métallique 31 et la troisième portion métallique 33 du cinquième support 30e sont orientées l'une par rapport à l'autre d'un angle d'orientation supérieur à 0°.

En l'occurrence, la deuxième portion métallique 32 du cinquième support 30e est orthogonale à la première portion métallique 31 et à la troisième portion métallique 33 du cinquième support 30e.

Le sixième support 30f présente une forme rectiligne et comporte une première portion métallique 31.

Les premières portions métalliques 31 des supports 30 sont parallèles entre elles et à l'axe X.

Les deuxièmes portions métalliques 32 des supports 30 sont parallèles entre elles et sont orthogonales à l'axe X.

L'orientation entre elles des portions métalliques est ici réalisée au moment de la fabrication du module électrique de puissance.

Cette orientation permet d'optimiser l'intégration du module électrique de puissance dans un boîtier ou dans un environnement quelconque. On peut en particulier orienter librement dans l'espace les accès aux entrées et aux sorties du module électrique de puissance et, notamment, aux connecteurs d'entrée et aux connecteurs de sortie situées sur les portions métalliques des supports.

Le premier transistor 21a et la première diode 22a sont tous deux fixés à la deuxième portion métallique 32 du premier support 30a et à la deuxième portion métallique 32 du deuxième support 30b en étant positionnés entre lesdites deuxièmes portions métalliques 32.

Une face du premier transistor 21a et une face de la première diode 22a sont fixées, par frittage d'un matériau de frittage comprenant une poudre d'argent, à la deuxième portion métallique 32 du premier support 30a.

Le premier support 30a est ainsi connecté électriquement au drain du premier transistor 21a et à la cathode de la première diode 22a

Une autre face du premier transistor 21a et une autre face de la première diode 22a sont fixées, par frittage du matériau de frittage, à la deuxième portion métallique 32 du deuxième support 30b.

Le deuxième support 30b est ainsi connecté électriquement à une source du premier transistor 21a et à une anode de la première diode 22a.

Le deuxième transistor 21b et la deuxième diode 22b sont fixés de la même manière aux deuxièmes portions métalliques 32 du deuxième support 30b et du troisième support 30c.

Le deuxième support 30b est ainsi connecté électriquement à une source du deuxième transistor 21b et à une anode de la deuxième diode 22b. Le troisième support 30c est ainsi connecté électriquement à un drain du deuxième transistor 21b et à une cathode de la deuxième diode 22b.

Le quatrième transistor 21d et la quatrième diode 22d sont fixés de la même manière aux deuxièmes portions métalliques 32 du troisième support 30c et du quatrième support 30d.

Le troisième support 30c est ainsi connecté électriquement à un drain du quatrième transistor 21d et à une cathode de la quatrième diode 22d. Le quatrième support 30d est ainsi connecté électriquement à une source du quatrième transistor 21d et à une anode de la quatrième diode 22d.

Le troisième transistor 21c et la troisième diode 22c sont fixés de la même manière aux deuxièmes portions métalliques 32 du quatrième support 30d et du cinquième support 30e.

Le quatrième support 30d est ainsi connecté électriquement à une source du troisième transistor 21c et à une anode de la troisième diode 22c. Le cinquième support 30e est ainsi connecté électriquement à un drain du troisième transistor 21c et à une cathode de la troisième diode 22c.

Le sixième transistor 21f et la sixième diode 22f sont fixés de la même manière aux deuxièmes portions métalliques 32 du troisième support 30c et du sixième support 30f.

Le troisième support 30c est ainsi connecté électriquement à un drain du sixième transistor 21f et à une cathode de la sixième diode 22f. Le sixième support 30f est ainsi connecté électriquement à une source du sixième transistor 21f et à une anode de la sixième diode 21f.

Le cinquième transistor 21e et la cinquième diode 22e sont fixés de la même manière aux deuxièmes portions métalliques 32 du cinquième support 30e et du sixième support 30f.

Le cinquième support 30e est ainsi connecté électriquement à un drain du cinquième transistor 21e et à une cathode de la cinquième diode 22e. Le sixième support 30f est ainsi connecté électriquement à une source du cinquième transistor 21e et à une anode de la cinquième diode 22e.

Les finitions des transistors 21 et des diodes 22, c'est à dire la métallisation de leurs contacts, peuvent comporter tout matériau métallique, et notamment les matériaux suivants : Ag, Au, Pd, Al, Cu, Ni, etc.

Des courant électriques de puissance, provenant ou à destination des transistors 21, circulent dans les portions métalliques 32 des supports 30.

Les courants électriques de puissance comprennent le courant électrique d'alimentation Ial, le premier courant de phase Ip1, le deuxième courant de phase Ip2 et le troisième courant de phase Ip3.

Le premier support 30a est relié au conducteur d'alimentation positive 10, et le courant d'alimentation Ial circule dans la première portion métallique 31 et dans la deuxième portion métallique 32 du premier support 30a. Le drain du premier transistor 21a et la cathode de la première diode 22a sont donc portés à la tension d'alimentation continue positive.

Le cinquième support 30e est relié au conducteur d'alimentation positive 10, et le courant d'alimentation Ial circule dans la première portion métallique 31 et dans la deuxième portion métallique 32 du cinquième support 30e. Le drain du troisième transistor 21c et du cinquième transistor 21e, et la cathode de la troisième diode 22c et de la cinquième diode 22e, sont donc portés à la tension d'alimentation continue positive.

Le troisième support 30c est relié au conducteur d'alimentation négative 11, et le courant d'alimentation Ial circule dans la première portion métallique 31 et dans la deuxième portion métallique 32 du troisième support 30c. Les sources du deuxième transistor 21b, du quatrième transistor 21d et du sixième transistor 21f, et les anodes de la deuxième diode 22b, de la quatrième diode 22d et de la sixième diode 22f sont donc portées à la tension d'alimentation continue négative.

Le premier courant de phase Ip1, le deuxième courant de phase Ip2 et le troisième courant de phase Ip3 circulent respectivement dans le deuxième support 30b, le quatrième support 30d et le sixième support 30f, à destination respectivement de la première phase Ph1, de la deuxième phase Ph2 et de la troisième phase Ph3 du moteur 3.

Le deuxième support 30b, le quatrième support 30d et le sixième support 30f sont recouverts au moins partiellement de céramique ferromagnétique 34. La céramique ferromagnétique 34 forme, sur ces supports, des filtres de parasites à haute fréquence. La céramique ferromagnétique est appliquée par la technique de la « fabrication additive », ou via une technologie de 3D-MID (pour *3D-Mechatronic Integrated Devices*).

L'épaisseur Es d'au moins un support 30 est telle que :

$$5.Ep < Es < 30.Ep,$$

où Ep est une épaisseur moyenne des puces des composants de puissance montés sur ledit support 30.

En référence à la figure 3, on note que le premier support 30a, le troisième support 30c, le cinquième support 30e et le sixième support 30f portent aussi des pistes 35 sur lesquelles circulent les courants électriques de commande Ic à destination des grilles des transistors 21.

Chaque transistor 21 présente une première face 36 comprenant un premier élément conducteur relié au drain du transistor 21 et un deuxième élément conducteur relié à la grille du transistor 21, et une deuxième face 37 comprenant un troisième élément conducteur relié à la source du transistor 21.

Comme on l'a vu plus tôt, le matériau de frittage 38 est disposé sur le premier élément conducteur, le deuxième élément conducteur et le troisième élément conducteur.

Entre le matériau de frittage 38 disposé sur le deuxième élément conducteur et la portion métallique 32, on trouve une piste 35 et une couche isolante 39. La couche isolante 39 isole la piste 35 de la portion métallique 32 du support 30 sur laquelle circule le courant de puissance (courant d'alimentation ou courant de phase).

La piste 35 comporte ici un matériau conducteur comprenant de l'argent et un oxyde. Le matériau conducteur est dispersé dans un liant sérigraphiable.

La couche isolante 39 comporte ici un matériau isolant inorganique de type fritte de verre. Le matériau isolant inorganique est dispersé dans un liant sérigraphiable.

Le module électrique de puissance 1 permet une dissipation de chaleur via un transfert d'énergie isotrope entre les transistors 21 au travers du substrat constitué par les supports 30.

La dissipation de chaleur est une dissipation trimodale simultanée, par conduction, convexion et radiation. La dissipation de chaleur peut être paramétrable, en utilisant un élément conducteur thermique pour fabriquer les supports 30, dont les contours favorisent une bonne émissivité. On utilisera avantageusement la technique de « fabrication additive » pour former ces contours.

On note par ailleurs que des composants électriques sont disposés sur la surface extérieure du module électrique de puissance 1. Les composants électriques comprennent la capacité de liaison 6, ainsi qu'un composant 40 et une puce 41. La puce 41 est reliée via un « câblage par fil » 42 (ou *wire bonding*) à une piste 43. Le substrat 44 sur lequel sont montés ces composants électriques est cette fois un substrat traditionnel.

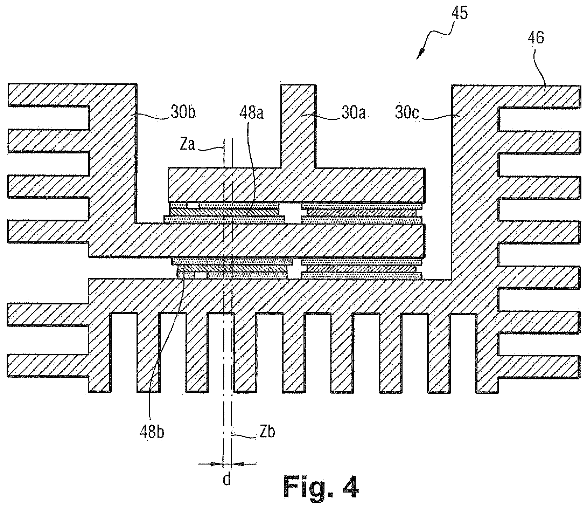

En référence à la figure 4, l'agencement des supports 30 est basé sur une cellule de puissance générique 45 qui comporte le premier support 30a, le deuxième support 30b et le troisième support 30c. On note que, sur la figure 4, le deuxième support 30b et le troisième support 30c sont munis d'ailettes de dissipation de chaleur 46 qui favorisent le refroidissement du module électrique de puissance.

Cette cellule générique 45, qui forme un bras de pont 16 comprenant un premier transistor 48a et un deuxième transistor 48b, peut être dupliquée autant de fois que nécessaire pour créer une fonction de puissance quelconque.

On note que le premier transistor 48a et le deuxième transistor 48b sont positionnés de part et d'autre du deuxième support 30b en étant superposés et centrés l'un par rapport à l'autre. Une distance d entre un premier axe Za perpendiculaire à une face du premier transistor 48a et passant par un centre de ladite face, et entre un deuxième axe Zb perpendiculaire à une face du deuxième transistor 48b et passant par un centre de ladite face, est inférieure ou égale au tiers d'une diagonale de la face ayant une surface la plus importante.

Cette cellule générique 45 peut être configurée différemment, c'est à dire que les supports 30 peuvent présenter des formes différentes, ou être disposés différemment les uns par rapport aux autres.

Une pluralité de cellules génériques 45 de formes diverses peut être utilisée pour réaliser un module électrique de puissance 1 conforme à tout type d'exigence d'intégration.

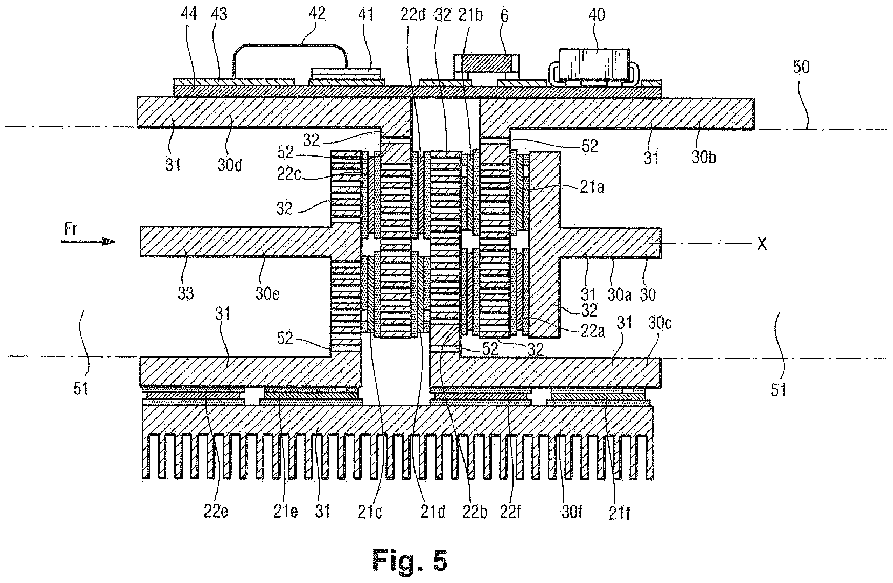

En référence à la figure 5, le module électrique de puissance 1 comporte un capot 50 étanche, fabriqué en plastique, de forme tubulaire. Le capot 50 est ici fixé au deuxième support 30b, au troisième support 30c, au quatrième support 30d et au cinquième support 30e.

Les supports 30 et le capot 50 définissent un canal 51 à l'intérieur du module électrique de puissance 1.

Un fluide de refroidissement Fr, par exemple un gaz ou un liquide caloporteur, circule ainsi dans le canal 51 défini par les supports 30 et par le capot 50. Le fluide traverse le deuxième support 30b, le troisième support 30c et le quatrième support par des orifices 52 pratiqués dans ces supports. La circulation du liquide de refroidissement dans le canal 51 permet de refroidir très efficacement le module électrique de puissance 1.

Le fluide de refroidissement assure une isolation du module électrique de puissance. La vitesse de circulation du fluide de refroidissement est ici d'environ 0,001m/s. La vitesse de circulation garantit l'absence d'apparition de décharges partielles lors des commutations électriques des interrupteurs formés par les transistors 21.

Les contours des supports 30 sont dimensionnés pour favoriser une grande surface d'échange avec le fluide de refroidissement.

Avantageusement, les supports 30 et, en particulier, les premières portions métalliques 31 et les deuxièmes portions métalliques 32, sont fabriqués en utilisant la technique de fabrication additive. Le matériau utilisé est par exemple l'aluminium. On peut ainsi définir des canaux de refroidissement à l'intérieur des premières portions métalliques 31 et des deuxièmes portions métalliques 32 des supports 30.

La performance thermique obtenue est inversement proportionnelle au diamètre des canaux de refroidissement, mais le bilan des pertes de charge hydraulique est lui proportionnel au diamètre des canaux de refroidissement.

Pour des diamètres des canaux de refroidissement compris entre $10\mu$m et $800\mu$m, on parle d'échangeurs de chaleur à micro-canaux. Pour des diamètres des canaux de refroidissement compris entre 1mm et 10mm, on parle d'échangeurs de chaleur à mini-canaux. Pour des diamètres des canaux de refroidissement supérieurs à 10mm, on parle de plaque froide.

Au cours de la fabrication du module électrique de puissance, un premier isolant est tout d'abord appliqué par sérigraphie en couche épaisse sur chaque face des supports 30 portant les transistors 21. Puis, les composants sont montés sur les supports 30, et le module électrique de puissance est assemblé. Un deuxième isolant est alors déposé par un procédé plasma, par un dépôt en phase vapeur, par évaporation ou par laminage. On forme ainsi un revêtement sans fissure et sans bulle, et qui présente des variations d'épaisseur inférieures à $1\mu$m. Ce revêtement recouvre et isole toutes les surfaces internes et externes du module électrique de puissance.

Le module électrique de puissance est enfin recouvert par une résine ou intégré dans un emballage de protection. On préserve ainsi l'isolement électrique de contraintes mécaniques extérieures susceptibles de provoquer des rayures, des chocs, des écrasements, etc. Les connecteurs d'entrée et de sortie, permettant de relier le module électrique de puissance à un moteur ou à un autre équipement, sont eux laissés libres.

Bien entendu, l'invention n'est pas limitée au mode de réalisation décrit mais englobe toute variante entrant dans le champ de l'invention telle que définie par les revendications.

Le module électrique de puissance décrit ici comprend un onduleur, mais l'invention peut bien sûr s'appliquer à tout type de module de puissance électrique mettant en œuvre tout type de fonction de puissance.

Le nombre de bras de pont pourrait bien sûr être différent, tout comme les composants de puissance utilisés.

Bien que l'on ait indiqué que les composants sont fixés par frittage aux supports, un moyen de fixation différent pourrait être utilisé, par exemple le brasage ou le collage.

On a décrit ici que les premières portions métalliques 31 et les deuxièmes portions métalliques 32 sont orthogonales entre elles. Une première portion métallique et une deuxième portion métallique orientées d'au moins un support pourraient cependant être orientées l'une par rapport à l'autre d'un angle d'orientation différent, supérieur à 0°.

On a aussi indiqué que l'orientation des portions métalliques est réalisée au moment de la fabrication du module électrique de puissance. On peut aussi prévoir que le ou les angles d'orientation soient réglés au moment de l'intégration du module électrique de puissance dans un boîtier contenant ledit module électrique de puissance. Les portions métalliques sont alors fixées entre elles par des moyens de fixation permettant d'effectuer le réglage de l'angle d'orientation.

**Revendications**

1. Module électrique de puissance comportant des composants de puissance (21, 22) et des supports (30) comprenant chacun au moins une portion métallique (31, 32), les portions métalliques des supports formant un substrat du module électrique de puissance (1), , chaque composant de puissance étant fixé à deux portions métalliques de deux supports distincts en étant positionné entre lesdites deux portions métalliques, le module électrique de puissance étant agencé de sorte que des courants électriques de puissance provenant ou à destination des composants de puissance circulent dans les portions métalliques des supports, au moins un support 30c, 30e) comprenant deux portions métalliques orientées l'une par rapport à l'autre d'un angle d'orientation supérieur à 0°, **caractérisé en ce que** les deux portions métalliques orientées sont orthogonales entre elles, et **en ce qu'** un composant de puissance distinct est fixé sur chacune desdites deux portions métalliques orientées.

2. Module électrique de puissance selon la revendication 1, dans lequel les deux portions métalliques orientées sont agencées de sorte que l'angle d'orientation peut être réglé au moment de l'intégration du module électrique de puissance dans un boîtier.

3. Module électrique de puissance selon la revendication 1, dans lequel les composants de puissance comprennent des composants pilotables (21), le module électrique de puissance comprenant des pistes (35) dans lesquelles circulent des courants électriques de commande (Ic) à destination des composants pilotables, chaque piste étant positionnée entre deux portions métalliques de deux supports distincts, chaque piste étant isolée d'une portion métallique (32) d'un support (30) par une couche isolante (39).

4. Module électrique de puissance selon la revendication 3, dans lequel au moins l'une des pistes (35) comporte un matériau conducteur comprenant de l'argent et un oxyde, le matériau conducteur étant dispersé dans un liant sérigraphiable.

5. Module électrique de puissance selon la revendication 3, dans lequel au moins l'une des couches isolantes (39) comporte un matériau isolant inorganique de type fritte de verre, le matériau isolant inorganique étant dispersé dans un liant sérigraphiable.

6. Module électrique de puissance selon la revendication 1, dans lequel une face de chaque composant de puissance (21, 22) est fixée à une portion métallique d'un support par frittage.

7. Module électrique de puissance selon la revendication 1, dans lequel les supports sont partiellement recouverts de céramique ferromagnétique (34) formant des filtres passe-bas.

8. Module électrique de puissance selon la revendication 1, dans lequel les supports délimitent un canal (51) à l'intérieur du module électrique de puissance, le module électrique de puissance étant agencé de sorte qu'un fluide circule dans le canal (51) pour refroidir le module électrique de puissance.

9. Module électrique de puissance selon la revendication 8, comprenant en outre un capot (50) étanche en plastique qui délimite aussi le canal, le capot étant fixé à des supports.

10. Module électrique de puissance selon la revendication 1, dans lequel les supports (30) sont fabriqués en utilisant une technique de fabrication additive.

11. Module électrique de puissance selon la revendication 1, dans lequel des canaux de refroidissement sont définis à l'intérieur des supports (30).

12. Module électrique de puissance selon la revendication 1, comprenant au moins trois supports (30).

13. Module électrique de puissance selon la revendication 1, dans lequel une épaisseur Es d'un support (30) est telle que :

$$5.Ep<Es<30.Ep,$$

où Ep est une épaisseur moyenne de puces des composants de puissance montés sur le support (30).

14. Module électrique de puissance selon la revendication 1, les composants de puissance comprenant deux transistors (21) et deux diodes (22) formant un bras de pont (16), le module électrique de puissance comprenant un premier support (30a) dans lequel circule un courant électrique d'alimentation sous une tension d'alimentation continue positive, un deuxième support (30b) dans lequel circule un courant de sortie alternatif, et un troisième support (30c) dans lequel circule un courant électrique d'alimentation sous une tension d'alimentation continue négative.

15. Module électrique de puissance selon la revendication 14, comprenant un premier transistor (48a) et un deuxième transistor (48b) d'un même bras de pont, le premier transistor (48a) et le deuxième transistor (48b) étant positionnés de part et d'autre d'un même support (30b) en étant superposés et centrés l'un par rapport à l'autre.

16. Module électrique de puissance selon la revendication 15, dans lequel une distance (d) entre un premier axe (Za) perpendiculaire à une face du premier transistor (48a) et passant par un centre de ladite face, et entre un deuxième axe (Zb) perpendiculaire à une face du deuxième transistor (48b) et passant par un centre de ladite face, est inférieure ou égale au tiers d'une longueur d'une diagonale de la face ayant une surface la plus importante.

17. Actionneur électromécanique comportant un module électrique de puissance selon la revendication 14 et un moteur électrique (3).

**Patentansprüche**

1. Elektrisches Leistungsmodul mit Leistungskomponenten (21, 22) und Trägern (30), die jeweils zumindest einen Metallabschnitt (31, 32) umfasst, wobei die Metallabschnitte der Träger ein Substrat des elektrischen Leistungsmoduls (1) bilden, wobei jede Leistungskomponente an zwei Metallabschnitten von zwei separat ausgebildeten Trägern befestigt ist, indem sie zwischen den beiden Metallabschnitten positioniert ist, wobei das elektrische Leistungsmodul derart ausgelegt ist, dass elektrische Leistungsströme in den Metallabschnitten der Träger von oder zu den Leistungskomponenten fließen, wobei zumindest ein Träger (30c, 30e) zwei gemäß einem Ausrichtwinkel von mehr als 0° zueinander ausgerichtete Metallabschnitte umfasst, **dadurch gekennzeichnet, dass** die beiden ausgerichteten Metallabschnitte zueinander orthogonal verlaufen und dass eine separat ausgebildete Leistungskomponente jeweils an einem jeden der beiden ausgerichteten Metallabschnitte befestigt ist.

2. Elektrisches Leistungsmodul nach Anspruch 1, wobei die beiden ausgerichteten Metallabschnitte derart ausgelegt sind, dass der Ausrichtwinkel anlässlich des Einbaus des elektrischen Leistungsmoduls in ein Gehäuse eingestellt werden kann.

3. Elektrisches Leistungsmodul nach Anspruch 1, wobei die Leistungskomponenten steuerbare Komponenten (21) umfassen, wobei das elektrische Leistungsmodul Bahnen (35) umfasst, in denen elektrische Steuerströme (Ic) zu den steuerbaren Komponenten fließen, wobei jede Bahn zwischen zwei Metallabschnitten von zwei separat ausgebildeten Trägern positioniert ist, wobei jede Bahn von einem Metallabschnitt (32) eines Trägers (30) durch eine Isolierschicht (39) isoliert ist.

4. Elektrisches Leistungsmodul nach Anspruch 3, wobei zumindest eine der Bahnen (35) ein leitfähiges Material enthält, das Silber und ein Oxid umfasst, wobei das leitfähige Material in einem siebdruckfähigen Bindemittel dispergiert ist.

5. Elektrisches Leistungsmodul nach Anspruch 3, wobei zumindest eine der Isolierschichten (39) ein anorganisches isolierendes Material wie etwa Glasfritte enthält, wobei das anorganische isolierende Material in einem siebdruckfähigen Bindemittel dispergiert ist.

6. Elektrisches Leistungsmodul nach Anspruch 1, wobei eine Fläche einer jeden Leistungskomponente (21, 22) durch Sintern an einem Metallabschnitt eines Trägers befestigt ist.

7. Elektrisches Leistungsmodul nach Anspruch 1, wobei die Träger teilweise mit Tiefpassfilter bildender, ferromagnetischer Keramik (34) bedeckt sind.

8. Elektrisches Leistungsmodul nach Anspruch 1, wobei die Träger einen Kanal (51) innerhalb des elektrischen Leistungsmoduls begrenzen, wobei das elektrische Leistungsmodul derart ausgelegt ist, dass in dem Kanal (51) ein Fluid zur Kühlung des elektrischen Leistungsmoduls fließt.

9. Elektrisches Leistungsmodul nach Anspruch 8, ferner umfassend eine abdichtende Abdeckung (50) aus Kunststoff, die den Kanal ebenfalls begrenzt, wobei die Abdeckung an Trägern befestigt ist.

10. Elektrisches Leistungsmodul nach Anspruch 1, wobei die Träger (30) unter Verwendung einer additiven Fertigungstechnik hergestellt sind.

11. Elektrisches Leistungsmodul nach Anspruch 1, wobei die Kühlkanäle im Inneren der Träger (30) definiert sind.

12. Elektrisches Leistungsmodul nach Anspruch 1, umfassend zumindest drei Träger (30).

13. Elektrisches Leistungsmodul nach Anspruch 1, wobei eine Dicke Es eines Trägers (30) die folgende Bedingung erfüllt:

$$5.Ep<Es<30.Ep,$$

, wobei Ep eine durchschnittliche Dicke von Chips der auf dem Träger (30) montierten Leistungskomponenten ist.

14. Elektrisches Leistungsmodul nach Anspruch 1, wobei die Leistungskomponenten zwei Transistoren (21) und zwei Dioden (22) umfassen, die einen Brückenarm (16) bilden, wobei das elektrische Leistungsmodul umfasst: einen ersten Träger (30a), in welchem ein elektrischer Versorgungsstrom mit einer positiven Versorgungs-Gleichspannung fließt, einen zweiten Träger (30b), in welchem ein Ausgangs-Wechselstrom fließt, und einen dritten Träger (30c), in welchem ein elektrischer Versorgungsstrom mit einer negativen Versorgungs-Gleichspannung fließt.

15. Elektrisches Leistungsmodul nach Anspruch 14, umfassend einen ersten Transistor (48a) und einen zweiten Transistor (48b) ein und desselben Brückenarms, wobei der erste Transistor (48a) und der zweite Transistor (48b) übereinander und zentriert zueinander liegend zu beiden Seiten ein und desselben Trägers (30b) positioniert sind.

16. Elektrisches Leistungsmodul nach Anspruch 15, wobei eine Distanz (d) zwischen einer ersten Achse (Za), die senkrecht zu einer Fläche des ersten Transistors (48a) und durch den Mittelpunkt von besagter Fläche hindurch verläuft, und einer zweiten Achse (Zb), die senkrecht zu einer Fläche des zweiten Transistors (48b) und durch den Mittelpunkt von besagter Fläche hindurch verläuft, kleiner oder gleich dem Drittel einer Länge einer Diagonale der Seite mit einer größten Oberfläche ist.

17. Elektromechanischer Aktuator, enthaltend ein elektrisches Leistungsmodul nach Anspruch 14 und einen Elektromotor (3).

## Claims

1. An electrical power module comprising power components (21, 22) and supports (30), each comprising at least one metal portion (31; 32), the metal portions of the supports forming a substrate of the electrical power module (1), each power component being fastened to two metal portions of two distinct supports by being positioned between said two metal portions, the electrical power module being arranged in such a manner that electrical power currents going to or coming from the power components flow in the metal portions of the supports, at least one support (30c, 30e) comprising two angled metal portions that are angled relative to each other at an angle that is greater than 0°, **characterized in that** the two angled metal portions are mutually orthogonal, and **in that** a distinct power component being fastened to each of said two angled metal portions.

2. An electrical power module according to claim 1, wherein the two angled metal portions are arranged in such a manner that the angle between them can be adjusted when the electrical power module is integrated in a housing.

3. An electrical power module according to claim 1, wherein the power components include controllable components (21), the electrical power module including tracks (35) for conveying electrical control currents (Ic) for the controllable components, each track being positioned between two metal portions of two distinct supports, each track being insulated from a metal portion (32) of a support (30) by an insulating layer (39).

4. An electrical power module according to claim 3, wherein at least one of the tracks (35) comprises a conductive material including silver and an oxide, the conductive material being dispersed in a binder suitable for silk-screen printing.

5. An electrical power module according to claim 3, wherein at least one of the insulating layers (39) comprises an inorganic insulating material of the glass frit type, the inorganic insulating material being dispersed in a binder suitable for silk-screen printing.

6. An electrical power module according to claim 1, wherein one face of each power component (21, 22) is fastened to a metal portion of a support by sintering.

7. An electrical power module according to claim 1, wherein the supports are partially covered in ferromagnetic ceramic (34) forming lowpass filters.

8. An electrical power module according to claim 1, wherein the supports define a channel (51) inside the electrical power module, the electrical power module being arranged in such a manner that a fluid flows in the channel (51) in order to cool the electrical power module.

9. An electrical power module according to claim 8, further including a leak-tight plastics material cover (50) that also defines the channel, the cover being fastened to supports.

10. An electrical power module according to claim 1, wherein the supports (30) are fabricated by using an additive fabrication technique.

11. An electrical power module according to claim 1, wherein cooling channels are defined inside the supports (30).

12. An electrical power module according to claim 1, including at least three supports (30).

13. An electrical power module according to claim 1, wherein a support (30) is of a thickness Es such that:

$$5.Ep<Es<30.Ep$$

where the chips of the power components mounted on said support (30) present a mean thickness of Ep.

14. An electrical power module according to claim 1, the power components include two transistors (21) and two diodes (22) forming a single bridge arm (16), the electrical power module including a first support (30a) in which there flows an power supply electric current at a positive DC power supply voltage, a second support (30b) in which there flows an AC output current, and a third support (30c) in which there flows an power supply electric current at a negative DC power supply voltage.

15. An electrical power module according to claim 14, including a first transistor (48a) and a second transistor (48b) forming a single bridge arm, the first transistor (48a) and the second transistor (48b) being positioned on either side of a single support (30b) so as to be superposed and centered relative to each other.

16. An electrical power module according to claim 15, wherein a first axis (Za) perpendicular to a face of the first transistor (48a) and passing through the center of said face is spaced apart from a second axis (Zb) perpendicular to a face of the second transistor (48b) and passing through the center of said face by a distance (d) that is less than or equal to one third of the length of a diagonal of the face having the larger area.

17. An electromechanical actuator comprising an electrical power module according to claim 15 and an electric motor (3).

Fig. 1

EP 3 714 667 B1

**Fig. 2**

**III—III**

**Fig. 3**

12

Fig. 4

Fr →

X

**Fig. 5**

EP 3 714 667 B1

## RÉFÉRENCES CITÉES DANS LA DESCRIPTION

**Documents brevets cités dans la description**

- US 2016105004 A1